Europäisches Patentamt

European Patent Office

Office européen des brevets

(11) Publication number: **0 243 063**
**A2**

# EUROPEAN PATENT APPLICATION

(21) Application number: **87303213.0**

(22) Date of filing: **13.04.87**

(51) Int. Cl.⁴: **H03C 3/09**

(30) Priority: **16.04.86 JP 88849/86**

(43) Date of publication of application:
**28.10.87 Bulletin 87/44**

(84) Designated Contracting States:
**DE GB NL SE**

(71) Applicant: **NEC CORPORATION**
**33-1, Shiba 5-chome, Minato-ku**
**Tokyo 108(JP)**

(72) Inventor: **Matsuura, Takashi**
**c/o NEC Corporation, 33-1 Shiba 5-chome**
**Minato-ku, Tokyo(JP)**

(74) Representative: **Orchard, Oliver John**
**JOHN ORCHARD & CO. Staple Inn Buildings**
**North High Holborn**
**London WC1V 7PZ(GB)**

(54) **Angle modulator.**

(57) An angle modulator operated intermittently and used with a frequency modulation type of a phase modulated type radio equipment, and others. A frequency control voltage and an input modulating signal are applied to individual terminals of a variable capacitance diode, so that a period of time necessary for the frequency control voltage to reach the variable capacitance diode may be shortened without being effected by a coupling capacitor which is adapted for the modulating signal and provided with great capacitance. This allows the center frequency of an output signal of the modulator to be rapidly tuned to a prescribed one after the start-up of the modulator.

Fig. 3

## ANGLE MODULATOR

### BACKGROUND OF THE INVENTION

The present invention relates to an angle modulator for use with frequency modulation type or phase modulation type radio equipment and others and, more particularly, to an angle modulator which is operated intermittently.

Radio equipment whose power consumption is severely limited, i.e., a one mounted in a motor vehicle is in many cases provided with a battery saving feature in order to activate its transmitting and receiving sections only when needed, thereby cutting down the power consumption. An angle modulator the output center frequency of which is actively controlled to a prescribed one is often required to have the output center frequency reaching the prescribed one immediately after the start of operation. This requirement is especially severe with an angle modulator which is applied to radio equipment of the type having a battery saving feature, because such a modulator is operated intermittently. However, a prior art angle modulator needs a substantial period of time for the center frequency of the output signal to be tuned to the prescribed one after the start of operation.

### SUMMARY OF THE INVENTION

It is therefore an object of the present invention to provide an angle modulator capable of causing the center frequency of an output signal thereof to be rapidly controlled to a prescribed center frequency after a start-up.

It is another object of the present invention to provide a generally improved angle modulator.

An angle modulator of the present invention comprises an oscillation circuit for providing an oscillation signal, a variable capacitance diode having a first terminal coupled to the oscillation circuit and a second terminal coupled to a modulating signal terminal via a first capacitor, for varying its instantaneous capacitance in response to a modulating signal supplied to the modulating signal terminal and for controlling its average capacitance with respect to time to determine the center frequeny of the oscillation signal in response to a frequency control signal, thereby providing angle-modulated oscillation signal, a frequency control voltage for providing the frequency control signal, and a first resistor and a second capacitor parallel-coupled between the second terminal and a terminal of fixed potential.

In accordance with the present invention, an angle modulator operated intermittently and used with a frequency modulation type of a phase modulated type radio equipment, and others is constructed such that a frequency control voltage and an input modulating signal are applied to individual terminals of a variable capacitance diode (or baractor), so that a period of time necessary for the frequency control voltage to reach the variable capacity diode may be shortened without being effected by a coupling capacitor which is adapted for the modulating signal and provided with great capacitance. This allows the center frequency of an output signal of the modulator to be rapidly tuned to a prescribed one after the start-up of the modulator.

The above and other objects, features and advantages of the present invention will become more apparent from the following detailed description taken with the accompanying drawings.

### BRIEF DESCRIPTION OF THE DRAWINGS

Fig. 1 is a block diagram showing a prior art angle modulator;

Fig. 2 is a graph representative of a frequency-to-time characteristic of an output signal which is particular to the prior art angle modulator of Fig. 1;

Fig. 3 is a block diagram showing an angle modulator embodying the present invention;

Fig. 4 is a graph showing a frequency-to-time characteristic attainable with the angle modulator of Fig. 3; and

Fig. 5 is a block diagram showing an exemplary radio equipment to which the present invention is applied.

### DESCRIPTION OF THE PREFERRED EMBODIMENT

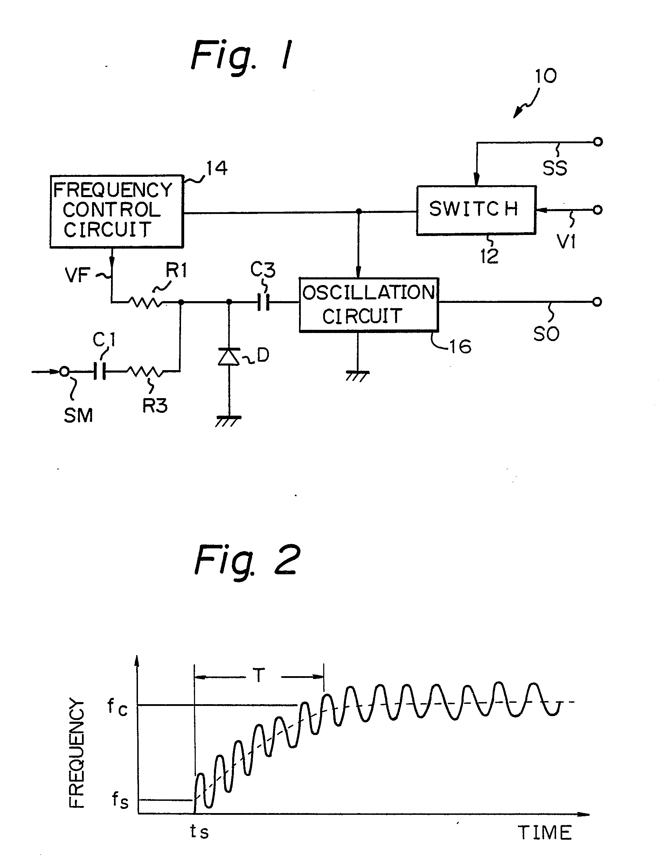

To better understand the present invention, a brief reference will be made to a prior art angle modulator, shown in Fig. 1. The prior art modulator, generally 10, includes a switch 12 which is opened and closed by a start control signal SS, a frequency control circuit 14 applied with a source voltage V1 via the switch 12 for generating a frequency control voltage VF, and an oscillation circuit 16 also impressed with the source voltage V1 via the switch 12 for oscillating an output signal SO. The modulator 10 further includes a variable capacitance diode D which is connected at one terminal (or anode) to ground and at the other terminal (or cathode) to the oscillation circuit 16 via a capacitor C3. The frequency control voltage VF is applied via a resistor R1 to the anode of the diode D, and an input modulating signal SM is applied to the anode of the diode D via a series connection of a capacitor C1 and a resistor R3.

When the switch 12 is closed by the start control signal SS, the source voltage V1 is fed to the frequency control circuit 14 and oscillation circuit 16 to enable them. The frequency control circuit 14 is adapted to produce the frequency control voltage VF for controlling the center frequency of an output signal to a prescribed center frequency. Specifically, the circuit 14 may be implemented with a temperature compensation circuit which produces, as the voltage VF, a voltage for compensating for the frequency-to-temperature characteristic of the oscillation circuit 16 in response to an ambient temperature, which is sensed by a temperature sensor; an automatic frequency control circuit which detects the frequency of an output signal and produces, as the voltage VF, a voltage that corresponds to a DC component of the detection output; or an automatic phase control circuit which compares in phase an output signal with a reference frequency signal and generates, as the voltage VF, a voltage which corresponds to a DC component of the comparison output.

The variable capacitance diode D is connected via the capacitor C3 to a resonant circuit which is adapted to determine the oscillation frequency of the oscillation circuit 16. Because the resonant frequency of the resonant circuit varies with the capacity of the diode D, the frequency of the output signal SO varies with the capacitance of the diode D. On the other hand, because the frequency control voltage VF controls the average capacitance of the diode D with respect to time via the resistor R1, the center frequency of the output signal SO is controlled by the voltage VF to a prescribed center frequency. In addition, because the input modulating signal SM changes the instantaneous capacitance of the diode D via the capacitor C1 and resistor R3, the frequency of the output signal SO is modulated by the signal SM.

Adapted for isolation, the resistors R1 and R3 are provided with relatively great resistance each. The capacitor C1 serves as a coupling capacitor for the modulating signal SM and is provided with relatively great capacity so that it may have a low impedance at the frequency of the modulating signal SM. Further, the capacitor C3 plays the role of a capacitor for coupling the diode D to the oscillation circuit 16 at the frequency of the output signal SO to thereby intercept the modulating signal SM. The capacitance of the capacitor C3 is predetermined to be sufficiently smaller than that of the capacitor C1 so that its impedance may become low at the frequency of the signal SO and become high at the frequency of the signal SM.

Referring to Fig. 2, a frequency-to-time characteristic of the signal SO as produced by the prior art modulator 10 is shown. Assume that the switch 12 of Fig. 1 is closed at a time ts to activate the modulator. Because a period of time T which is equal to (R1 + R3)C1 is necessary for the frequency control voltage VF to reach the diode D after the deliver from the frequency control circuit 14, the center frequency (indicated by a dotted curve in Fig. 2) is fs at the time of start-up ts and, then, increased to reach a prescribed center frequency fc upon the lapse of the time T (let the signal source impedance of the modulating signal SM and the output impedance of the circuit 14 be negligibly small). Because the resistance of the resistor R1 and the capacitance of the capacitor C1 are relatively great, the period of time T is relatively long.

As discussed above, in prior art angle modulator, the time constant determined by isolation resistors R1 and R3 and the coupling capacitor C1 is relatively large. Hence, the frequency control voltage takes a long period of time to reach a variable capacitance diode resulting that the convergence of the center frequency of an output signal to a prescribed one after the start-up is slow.

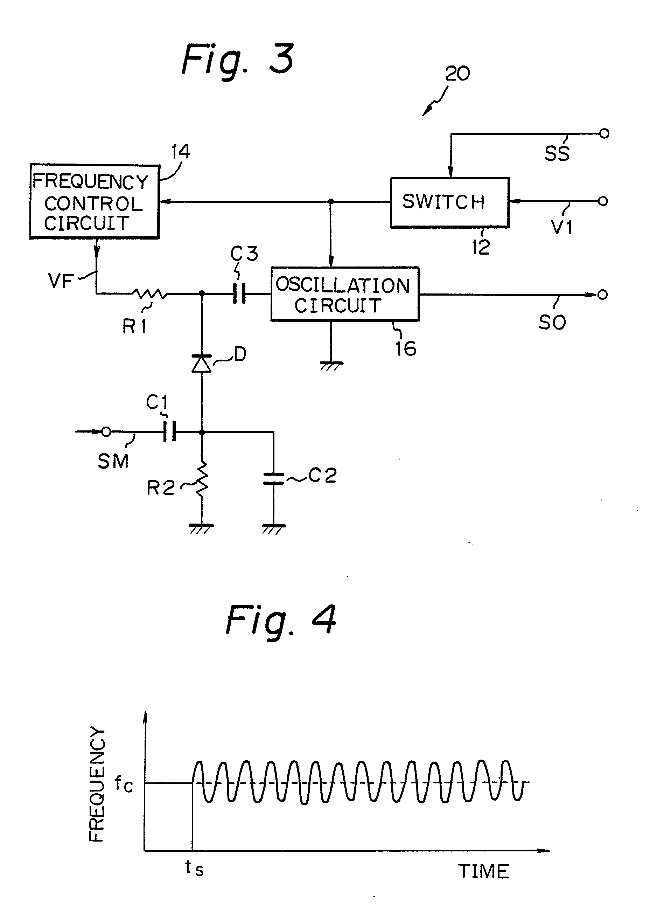

Referring to Fig. 3, an angle modulator embodying the present invention and free from the above drawback is shown in a block diagram. In this figure, the same or similar structural elements as those shown in Fig. 1 are designated by like reference numerals. The modulator of the present invention, generally 20, comprises a switch 12 which is opened and closed by a start control signal SS, a frequency control circuit 14 applied with a source voltage V1 via the switch 12 for producing a frequency control voltage VF, an oscillation circuit 16 also applied with the source voltage V1 via the switch 12 for oscillating an output signal SO, and a variable capacitance diode D which is connected at one terminal (cathode) to the frequency control circuit 14 via a resistor R1 and to the oscillation circuit 16 via a capacitor C3 and, at the other terminal (anode) to ground via a parallel connection of a resistor R2 and a capacitor C2. An input modulating signal SM is applied via a coupling capacitor C1 to the anode of the diode D. It is to be noted that the switch 12, frequency control circuit 14, oscillation circuit 16, diode D, resistor R1, capacitor C1 and capacitor C3 are identical in construction and operation with those of the prior art modulator, as shown in Fig. 1.

The capacitor C2 is provided with capacitance with is such that the impedance of the capacitor C2 becomes low at the frequency of the output signal SO and becomes high at the frequency of the modulating signal SM. The resistor R2 constitutes terminating resistance for the signal SM. At the frequency of the output signal SO, because the cathode of the diode D is connected to a resonant circuit associated with the oscillation circuit 16 via the capacitor C3 while the anode of the same is grounded via the capacitor C2, the frequency of the signal SO varies with the capacitance of the diode D. Since the direct current flowing from the cathode of the diode D to the anode is negligibly small, the voltage impressed across the diode D is equal to the frequency control voltage VF. At the frequency of the modulating signal SM, the cathode of the diode D remains constant in voltage, VF, and the anode of the diode D is applied with the modulating signal SM via the capacitor C2, so that the signal SM is applied across the diode D. It follows that the center frequency of the signal SO is tuned to the prescribed one by the frequency control voltage VF and modulated in frequency by the input signal SM.

Fig. 4 shows a graph representative of a frequency-to-time characteristic of the output signal SO in accordance with the embodiment of Fig. 3. Because the capacitance of the diode D is very small and so is the capacitance of the capacitor C3, the frequency control voltage VF left the frequency control circuit 14 reaches the diode D immediately if the time constant for the capacitors D and C3 to be charged via the resistor R1 is neglected. Hence, assuming that the modulator 20 of Fig. 3 is started up at a time ts, the center frequency of the output signal SO is controlled to the prescribed one fc instantaneously, as shown in Fig. 4.

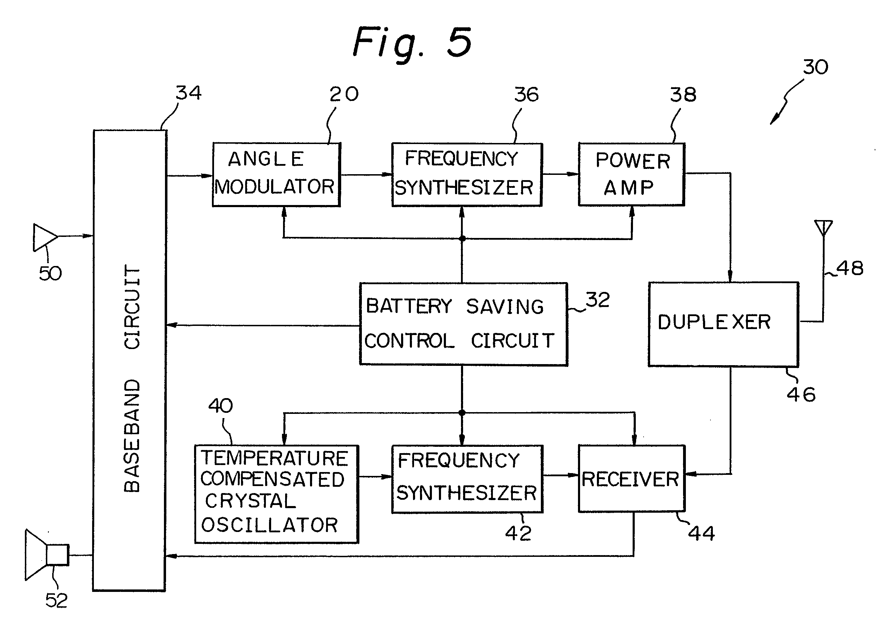

Referring to Fig. 5, exemplary radio equipment with the angle modulator 20 of the present invention is shown. The equipment, generally 30, is provided with the angle modulator 20, a battery saving control circuit 32, a baseband circuit 34, frequency synthesizers 36 and 42, a power amplifier 38, a temperature compensated crystal oscillator 40, a receiver 44, a duplexer 46, an antenna 48, a microphone 50 and a speaker 52, which are connected as shown in the figure.

In the equipment, the battery saving control circuit 32 provides a control signal corresponding to the above-mentioned control signal SS. In response to the ON/OFF control signal, a switch (not shown) feeds the voltage of a power source (not shown) to the circuits 20, 34, 36, 38, 40, 42 and 44 to activate them. In such a state, an audio signal picked up by the microphone 50 is applied as the modulating signal SM to the modulator 20 via the baseband circuit 34 including an audio amplifier and a filter.

In the modulator 20, the switch 12 (Fig. 3) is opened and closed in response to the control signal SS to control the supply of the voltage V1 of the power source to the circuits 14 and 16. Upon the closing of the switch 12, the oscillator 16 provides an angle-modulated output signal SO which is converted by the frequency synthesizer 36 and amplified by the power amplifier 38. The output of the amplifier 38 is sent to remotely located radio equipment via the duplexer 46 and the antenna 48.

The radio signal sent from the remotely located radio equipment is packed by the antenna 48 and received by the receiver 44 via the duplexer 46. The receiver 44 frequency-converts and demodulates the radio signal with the output of the synthesizer 42. The demodulated signal is amplified by another amplifier included in the baseband circuit 34, and sounded by the speaker 52.

In summary, it will be seen that the present invention provides an angle modulator which allows the center frequency of its output signal to be rapidly tuned to a predetermined one after a start-up of the modulator. This unprecedented advantage is derived from a unique construction wherein a frequency control voltage and an input modulating signal are applied to individual terminals of a variable capacitance diode, so that the period of time necessary for the frequency control voltage to reach the diode is shortened without being effected by a coupling capacitor which is adapted for the modulating signal and provided with great capacitance. The present invention will prove particularly effective when applied to an angle modulator which is operated intermittently, e.g. a one which is built in a radio equipment having a battery saving feature.

Various modifications will become possible for those skilled in the art after receiving the teachings of the present disclosure without departing from the scope thereof. 1912

## Claims

1. An angle modulator comprising:
an oscillation circuit for providing an oscillation signal;
a variable capacitance diode having a first terminal coupled to said oscillation circuit and a second terminal coupled to a modulating signal terminal via a first capacitor, for varying its instantaneous capacitance in response to a modulating signal supplied to said modulating signal terminal and for controlling its average capacitance with respect to time to determine the center frequency of said oscillation signal in response to a frequency control signal, thereby providing angle-modulated oscillation signal;

a frequency control voltage for providing said frequency control signal; and

a first resistor and a second capacitor parallel-coupled between said second terminal and a terminal of fixed potential.

2. An angle modulator as claimed in claim 1, wherein a second resistor is connected between said frequency control circuit and said first terminal.

3. An angle modulator as claimed in claim 1, wherein a third capacitor is connected between said oscillation circuit and said first terminal.

4. An angle modulator as claimed in claim 1, wherein the first capacitor has a low impedance at a frequency of said modulating signal.

5. An angle modulator as claimed in claim 1, wherein the second capacitor has a low impedance at a frequency of said oscillation signal and a high impedance at a frequency of said modulating input signal.

6. An angle modulator as claimed in claim 1, wherein said frequency control circuit is intermittently activated in response to an ON/OFF control signal.

7. An angle modulator as claimed in claim 6, wherein said ON/OFF control signal comprises a control signal for battery saving.

# Fig. 1

# Fig. 2

# Fig. 3

20

SS

FREQUENCY
CONTROL
CIRCUIT — 14

SWITCH

V1

12

VF

R1

C3

OSCILLATION
CIRCUIT

16

SO

D

C1

SM

R2

C2

# Fig. 4

# Fig. 5

0 243 063